# EUROPEAN PATENT SPECIFICATION

(11) **EP 1 183 707 B1**
(45) Date of publication and mention of the grant of the patent: **07.10.2009**
(21) Application number: 00936340.9
(22) Date of filing: 25.05.2000
(51) Int. Cl.: H01J 37/26, H01J 37/02

(54) **APPARATUS AND METHODS FOR SECONDARY ELECTRON EMISSION MICROSCOPY WITH DUAL BEAM**
GERÄT UND VERFAHREN ZUR SEKUNDÄRELEKTRONEN-MIKROSKOPIE MITTELS DOPPELTEN STRAHLES
APPAREIL ET PROCEDES DE MICROSCOPIE PAR EMISSION ELECTRONIQUE SECONDAIRE A DOUBLE FAISCEAU

(30) Priority: 25.05.1999 US 135742 P; 16.07.1999 US 354948; 25.05.2000 US 579867
(43) Date of publication of application: 06.03.2002
(73) Proprietor: KLA-Tencor Corporation, San Jose, CA 95134-1809 (US)
(72) Inventor: VENEKLASEN, Lee, Castro Valley, CA 94546 (US); ADLER, David, San Jose, CA 95120 (US)
(74) Representative: Browne, Robin Forsythe
(86) International application number: PCT/US2000/014583
(87) International publication number: WO 2000/072355

(56) References cited:
- EP-A- 0 266 535
- EP-A- 0 417 354
- EP-A- 0 593 216
- EP-A- 0 594 394
- DE-A- 3 621 045
- US-A- 4 399 360
- US-A- 4 877 326
- VENEKLASEN L H: "THE CONTINUING DEVELOPMENT OF LOW-ENERGY ELECTRON MICROSCOPY FOR CHARACTERIZING SURFACES" REVIEW OF SCIENTIFIC INSTRUMENTS,US,AMERICAN INSTITUTE OF PHYSICS. NEW YORK, vol. 63, no. 12, 1 December 1992 (1992-12-01), pages 5513-5532, XP000330409 ISSN: 0034-6748 cited in the application

## Description

### BACKGROUND OF THE INVENTION

The present invention relates generally to an apparatus and a method for using electron beams to microscopically inspect the surface of an object, and more particularly to inspect layers in a semiconductor device.

A variety of methods have been used to examine microscopic surface structures of semiconductors. These have important applications in the field of semiconductor chip fabrication, where microscopic defects at a surface layer make the difference between a functioning and a nonfunctioning chip. For example, holes or vias in an intermediate insulating layer often provide a physical conduit for an electrical connection between two outer conducting layers. If one of these holes or vias is inadequately etched or becomes clogged with foreign material, it will be impossible to establish this electrical connection and the whole chip may fail. Examination of the microscopic defects in the surface of the semiconductor layers is necessary to ensure proper functioning of the chips.

Electron beams have several advantages over other mechanisms to examine samples. Light beams have an inherent resolution limitation of about 100nm-200nm, but electron beams can investigate feature sizes as small as a few nanometers. Electron beams are manipulated fairly easily with electrostatic and electromagnetic elements, and are certainly easier to produce and manipulate than x-rays.

Electron beams in semiconductor defect inspection do not produce as many false positives (elements inaccurately identified as defective) as optical beams. Optical beams are sensitive to problems of color noise and grain structures whereas electron beams are not. Oxide trenches and polysilicon lines are especially prone to false positives with optical beams due to grain structure.

A variety of approaches involving electron beams have been utilized for examining surface structure. In low-voltage scanning electron microscopy (SEM), a narrow beam of primary electrons is raster-scanned across the surface to emit secondary electrons. If the primary electrons in the beam of scanning electron microscopy are near a particular known electron energy (called E2), there is a minimal corresponding charge build-up problem associated with SEM, and the surface of the sample remains relatively neutral. However, raster scanning a surface with scanning electron microscopy is slow because each pixel on the surface is collected sequentially. Moreover, a complex and expensive electron beam steering system is needed to control the beam pattern.

Another approach is called Photo-Electron Emission Microscopy (PEM or PEEM), in the which photons are directed at the surface of the sample to be studied, and by the photoelectric effect, electrons are emitted from the surface. On an insulating surface, the emission of these electrons, however, produces a net positive charge on the sample surface since there is a net flux of electrons from the surface. The sample continues to charge positively until there are no more emitted electrons, or electrical breakdown occurs. This charge build-up is especially problematic when imaging insulator materials.

Another method of examining surfaces with electron beams is known as Low Energy Electron Microscopy (LEEM), in which a relatively wide beam of low-energy electrons is directed to be incident upon the surface of the sample, and electrons reflected from the sample are detected. However, LEEM suffers from a similar charge build-up problem since electrons are directed at the sample surface, but not all of the electrons are energetic enough to leave the surface, which repels further electrons from striking the sample, resulting in distortions and shadowing of the surface.

Several prior art publications have discussed a variety of approaches using electron beams in microscopy, but none have determined how to do so with parallel imaging, while at the same time reducing or eliminating the charge build-up problem. One of these approaches is described by Lee H. Veneklasen in "The Continuing Development of Low-Energy Electron Microscopy for Characterizing Surfaces," Review of Scientific Instruments, 63 (12), December 1992, Pages 5513 to 5532. Veneklasen notes generally that the LEEM electron potential difference between the source and sample can be adjusted between zero and a few keV, but he docs not recognize the charging problem or propose a solution to it.

EP-0417354 describes an electron beam apparatus having an electron source for generating an electron beam to irradiate a specimen located in a field space of an electron lens of the apparatus. An auxiliary electron source is provided for generating an electron beam of low energy electrons to be injected into the lens field space and to be directed to the surface of the specimen by the same lens field.

EP-0266535 describes an electron beam system and method for testing three dimensional networks of conductors embedded in an insulating material specimen. Top to top surface wiring is tested by irradiating the specimen with an electron beam at a first beam potential to charge the specimen while negatively biassing a grid placed above the specimen surface. Selected portions of the specimen are then irradiated with an electron beam at a second beam potential to read the charge on selected conductors while applying a zero or a positive bias to the grid. The charge beam is a focussed scanning beam and the first beam potential is greater than the second beam potential.

Top to top surface wiring is tested electrically without making physical electrical contact. The system comprises two flood beams and a focus probe beam with one flood beam located at either side of the specimen. Choice of acceleration potentials, beam currents and dwell times of the beams allows alteration of the secondary electron emission from the specimen in such a way that electrical properties of the conductor networks can be measured directly.

EP0594394 describes an electron spectroscopy analyser and method which has first and second electron beams, a secondary electron detector and a spectrum analyser and electron detector. The second electron source is used to shift the energy of the reflected electrons which thereby shifts electron spectroscopy spectrum.

US4399360 describes a transmission electron microscope in which a beam of electrons which has passed through a sample are deflected with deflection plates to produce a TV-type raster scan of the electron beam through an aperture plate to a electron detector. The signal for the detector is used to generate a video display.

EP0593216 describes a transmission electron microscope comprising a four panel detector which allows the deflection of an electron beam to be measured.

Thus, there remains a need for methods and apparatus that utilize electron beams to investigate sample surfaces, while minimizing charge build-up problems and increasing the speed of examining sample surfaces.

A first aspect of the invention provides an apparatus for inspecting a sample comprising: a first electron beam generator arranged to direct a first electron beam having a first range of energy levels toward a first area of the sample; a second electron beam generator arranged to direct a second electron beam having a second range of energy levels toward a second area of the sample, wherein the second area of the sample at least partly overlaps with the first area and the second range of energy levels are different from the first range such that charge build up on the sample surface caused by the first electron beam is minimized; wherein the first and second electron beam generators comprise a first electron gun source arranged to generate the first electron beam and a second electron gun source arranged to generate the second electron beam; and, a detector arranged to detect secondary electrons originating from the sample as a result of the first and second electron beam interacting with the sample so as to image a plurality of pixels in parallel; wherein the first electron beam generator is adapted to generate a first electron beam having a width sized to produce a spot size on the surface of the sample in the range of 0.1 to 100 millimetres; wherein the detector is adapted to image between 500,00 and 1,000,000 pixels in parallel; and, wherein the apparatus further comprises a magnetic beam separator arranged to direct the first and second electron beams toward the sample and bend the secondary electrons along an image path on to the imaging plane of the detector.

A second aspect of the invention provides a method for controlling charging of a surface of a sample while exposing the surface to a beam of charged particles, comprising: exposing the surface of the sample to a first set of electrons in a first electron beam, the first set of electrons having energies within a first range; exposing the surface to a second set of electrons in a second electron beam, the second set of electrons having energies within a second range, different from the first range, such that charge build up on the sample surface caused by the first electron beam is minimized; and detecting secondary electrons originating from the sample as a result of the first and second electron beams interacting with the sample so as to image a plurality of pixels in parallel, wherein the first electron beam has a width sized to produce a spot size on the surface of the sample in the range of 0.1 to 100 millimetres; wherein the detector images between 500,000 and 1,000,000 pixels in parallel; and wherein the first and second beams are directed towards the sample by a magnetic beam separator and the secondary electrons are bent along an image path on to the imaging plane of the detector by the magnetic beam separator.

In general terms, a first beam is used to generate an image of a relatively wide area of a sample. Parallel imaging is accomplished by using a relatively wide beam. A second beam having a lower landing energy than the first beam may be used in order to reduce positive charge build up on the sample that may result from the first beam.

The present invention has several advantages. For example, the apparatus and methods allow imaging of a large number of pixels in parallel on a detector array, and thereby has the properties of being faster and lower in noise than conventional Scanning Electron Microscopes and methods. Additionally, electron beam scanning systems are not required, and the electron beam current densities are not as high so that the probability of damaging sensitive samples is lessened.

These and other features and advantages of the present invention will be presented in more detail in the following specification of the invention and the accompanying figures which illustrate by way of example the principles of the invention.

### BRIEF DESCRIPTION OF THE DRAWINGS

The present invention will be readily understood by the following detailed description in conjunction with the accompanying drawings, wherein like reference numerals designate like structural elements, and in which:
Figure 1 shows the basic configuration for the Secondary Electron Emission Microscopy (SEEM) apparatus having dual beams in accordance with one embodiment of the present invention.
Figure 2 is a graph of the relationship between the charge balance yield ratio and the primary electron energy in a system having a single beam.
Figure 3 is a chart comparing the SEEM technique of the invention to prior art electron beam inspection techniques.
Figure 4 illustrates an imaging method of SEM.
Figure 5 illustrates an imaging method of SEEM for comparison with Figure 4.
Figure 6(a) shows how the electron beam of SEEM detects a defect (an obstruction) in a via of an insulating layer.
Figure 6(b) shows how the electron beam of SEEM inspects metal lines connecting vias.
Figure 7 shows how the electron beam of SEEM is used to study biological samples.

### DETAINED DESCRIPTION OF SPECIFIC EMBODIMENTS

Reference will now be made in detail to the specific embodiments of the invention. Examples of the these specific embodiments are illustrated in the accompanying drawings. While the invention will be described in conjunction with these specific embodiments, it will be understood that it is not intended to limit the invention to the described embodiments. On the contrary, it is intended to cover alternatives and modifications as may be included within the scope of the invention as defined by the appended claims. In the following description, numerous specific details are set forth in order to provide a thorough understanding of the present invention. The present invention may be practiced without some or all of these specific details. In other instances, well known process operations have not been described in detail in order not to unnecessarily obscure the present invention.

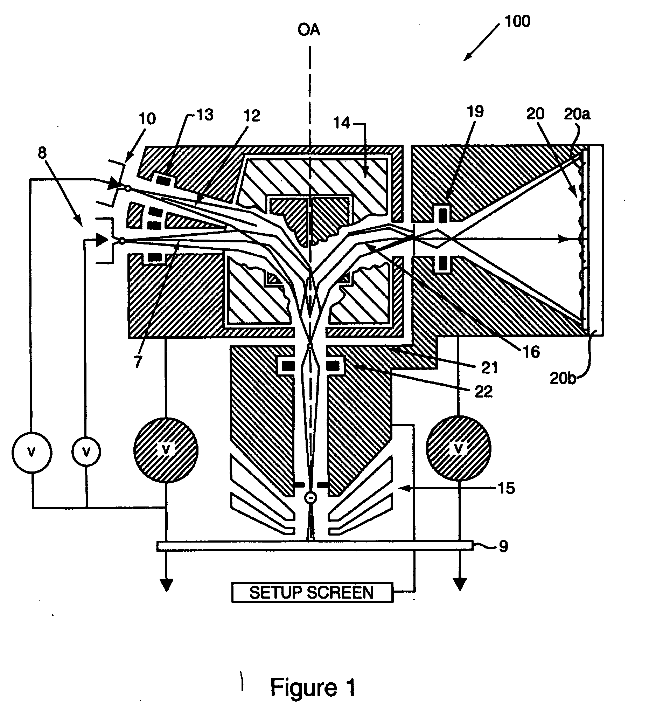

Figure 1 shows the basic configuration for the Secondary Electron Emission Microscopy (SEEM) apparatus 100 having dual beams in accordance with one embodiment of the present invention. The SEEM 100 includes two electron gun sources 10 and 8 that each emits a beam of primary electrons e₁ along paths 12 and 7, respectively.

The electron beams are each collimated by electron lens 13 and continue along paths 12 and 7. Magnetic beam separator 14 then bends the collimated electron beams so that they are incident along electron optical axis OA normal to the surface of a sample 9 to be inspected. In other words, the two beams may be directed to strike a same general area of the sample at about the same time.

The landing energy of one of the beams is selected to balance charge on the surface of the sample. In one embodiment, one of the beams has a landing energy on the order of 1 keV. Although the landing energy of the first beam may be selected to result in a neutrally charged sample, in certain types of materials (*e*.*g.*, insulators) the first beam results in a net positive charge build up on the surface of the sample. That is, electrons are lost from the sample due to a strong electric field that is produced at the surface by the higher energy beam. Thus, a second beam having a lower landing energy is used in conjunction with the first higher energy beam to reduce any positive charge build up on the sample resulting from the higher energy beam. The lower energy beam preferably has an energy of approximately zero eV.

In theory, the landing energy of the second beam is selected to lock the surface voltage of the sample into a predetermined voltage value. When a lower voltage beam is used, the surface of the sample seems to be electrically connected by a wire to an electrode (i.e., the source of the electrons of the second lower beam). This voltage locking mechanism provides a way to automatically lock in the surface such that the surface does not charge even for a relatively broad range of substrate materials.

In one embodiment, the lower energy beam has a landing energy of about 0 eV, which value facilitates reduction of positive charge build up resulting from the higher energy beam. In theory, the electrons within the lower energy are insufficiently energetic to cause the emission of secondary or backscattered electrons. These lower energy electrons compensate for any surface charging that might otherwise have been produced by the higher energy beam. The lower energy electrons will land on the surface if the surface becomes positively charged, and will eliminate this positive charge. If the surface is not sufficiently positively charged, these electrons will not land.

Objective electron lens 15 focuses the primary electrons, e₁ into two overlapping beams. Preferably, the lower energy beam has a same or larger spot size than the higher energy beam. That is, the lower energy beam falls on a spot that is equal to or encompasses the spot of the higher energy beam. Thus, the lower energy beam may facilitate reducing the positive charge build up that is present within the entire spot area of the higher energy beam. A larger spot size for the lower energy beam may be required to compensate for misalignments within the beam focusing system.

The size of the electron beam spots on the sample 9 from the two beams are in the range of 0.1 to 100 millimeters, and more preferably are about one to two millimeters. The size of this beam at the sample and imaging planes is optionally variable with a zoom imaging system to control the resolution and rate of acquiring the image. In any event, if it is desired to eliminate edge effects, the beam widths should be larger than, and preferably at least twice the characteristic dimension of, the detector at the image plane.

Primary electrons e₁ incident on the sample 9 produce electrons e₂ (which could be secondary, backscattered or mirrored) which travel back along the axis OA perpendicular to the inspection surface to objective electron lens 15, where they are recollimated. Magnetic beam separator 14 bends the electrons e2 to travel along image path 16. The electron beam along image path 16 is focused by projection electron lens 19 onto an imaging plane of detector 20.

The detector 20 may be in any suitable form for detecting the secondary electrons. For example, the detector 20 may include an electron imager (*e*.*g*., as shown, a YAG screen 20a) for converting the electron beam into a light beam. The light beam may then be detected by a camera or preferably a lime delay integrating (TDI) optical or electron detector 20b. The operation of a TD1 optical detector is disclosed in U.S. Patent No. 4,877,326 to Chadwick et al,

Alternatively, the image information may be processed directly from a back thinned TDI electron detector without using an electron imager or YAG scree. Signals collected from the TDI detector can be processed and compared with other data to inspect the substrate and to identify and/or classify possible defects and other features thereon. Such processing and comparison could be performed in a die to die mode, in which nominally identical portions of selected semiconductor die arc compared to one another, and differences therein may represent defects. Such processing and comparison could instead or additionally be performed in an array mode, in which nominally identical portions of a repeating array present on a single semiconductor die are compared to one another, and differences may again represent defects. Or such processing and comparison could be performed in a die to database mode, in which data (e.g, images) from the inspected portion of the substrate is compared to corresponding data derived from a reference database. The reference database may be derived from or identical to the database used to create the images present on the inspected portion of the substrate. Alternatively, the reference database could be derived from other rules corresponding to the expected images of the structures, such as arrays or other repeating structures or test structures which may have a partially repeating or predictably changing design.

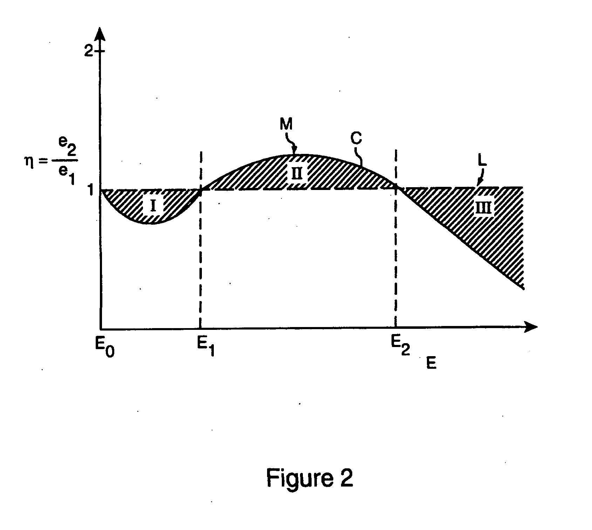

Figure 2 is a graph showing the charge ratio versus primary electron energy characteristic of single incident electron beam inspection techniques such as LEEM, SEM and SEEM. Yield ratio η is defined as the number of electrons emitted by the surface, e₂, divided by the number of electrons incident on the surface, e₁. Yield ratio η thus defines the amount of charge build-up on the surface being inspected since there will be a net charge build-up wherever η does not equal unity. A yield ratio of greater than one implies that more electrons are being emitted than are incident, resulting in a net positive charge at the surface, and conversely a yield ratio of less than one indicates that more electrons are incident on the surface than are being emitted, resulting in a negative charge build-up.

Yield curve C indicates the experimentally-derived mathematical function that defines the yield ratio at various incident election energies, E, for a typical sample substance. As shown Figure 2, line L is the line of charge balance, η = 1, and there are only three points on yield curve C where charge balance is achieved, i.e. e₂/e₁ = 1. These three points are E₀ = 0, E₁, and E₂. (Energy E₀= 0 is uninteresting for present purposes since it represents a situation where no electrons are incident on the sample.) In the region I between line L and yield curve C, there is an excess of negative charge since e₂ is greater than e₁. In region II, between line L and yield curve C, there is an excess of positive charge since e1 is greater than e₂, i.e. more secondary electrons are emitted than primary electrons are incident. In region III, between line L and curve C, the charge build-up again becomes negative.

One can see from Figure 2 that on yield curve C there are only two significant points, E₁ and E₂, where there is likely to exist a charge balance. The problem is that only point E₂ is actually stable. That is, if the energy, E, of the primary electrons incident on the sample surface varies in either direction from E₁ by small amount, say ΔE₁, the charge balance is quickly lost. Charge balance η becomes increasingly negative or increasingly positive depending upon whether E₁ was approached from the +ΔE₂ or -ΔE₂ tends to return the beam energy to point E₂. The value to of E₁ or E₂ have been experimentally determined from a variety of substances, such s silicon dioxide, aluminum, and polysilicon. While each substance has its own characteristic yield curve C, the general shape of these yield curves is as shown.

Figure 2 illustrates graphically the problem with past techniques of electron beam inspection, and shows why the SEEM technique described in the parent application provides unexpected advantages. Low Energy Electron Microscopy (LEEM) generally operated below E₁, with electron energies of 100 eV or less. Since point E₁ is unstable, LEEM suffered from the problem of charge build-up. Scanning Electron Microscopy (SEM) operated just below E₂ is stable, there was no problem with charge build-up in SEM, but SEM is slow precisely because it requires scanning. Prior to the present invention, it is believed that none had thought to drive the relatively wide beam of the LEEM parallel imaging system at a relatively high energy (*e*.*g*., E₂), as is recognized by the SEEM technique of the invention. The SEEM technique of the present invention is therefore the first recognition of the advantages of combining the parallel imaging of LEEM with the charge balance of SEM.

Although in theory, one may operate a relatively wide beam at E₂, it may be difficult to maintain the wide beam at a stable landing energy (*e*.*g*., E₂) without charge build-up occurring on the sample. Since the E₂ value depends on material composition, the E₂ value will necessarily vary as the beam moves across the sample and over various structures having different material compositions. Thus, even though the SEEM apparatus may be initially configured to operate at E₂ for an initial beam position on a first material of the sample, the landing energy will move away from E₂ as the beam moves across a different material on the sample. Accordingly, the present invention provides a second beam at a lower landing energy to compensate for any charge build up that may occur.

The first beam does not operate at E₂ in order to minimize charge build up since the second beam compensates for positive charge build up. Preferably, the high-energy beam operates between E₁ and E₂, and more preferably operates at the yield peak between E₁ and E₂. A local charge equilibrium may be automatically established by the appropriate selection of energy and flux of the beams such that the potential of the surface is locked within a selected range. The high-energy beam energy may be selected to have a positive-charging effect on the sample surface (e.g., yield is greater than 1). Thus, the high-energy beam causes more secondary and backscattered electrons to he ejected from the surface than are absorbed from the incident high-energy beam. For example, a landing energy in the range of about 100 eV to about 2000 eV may be used for most materials. The low-energy beam energy is selected so that the beam is attracted to a positively charged sample surface and neutralizes such positive charge. A low-energy beam with a current density that is at least twice that of the high-energy beam seems to work well to maintain voltage equilibrium on the sample surface, and is therefore preferred.

It is important to note that for purposes of the above description the primary electron energy is to be measured at the surface of the sample. The energy of the electrons focused by objective electron lens 15 is generally different than the energy of the electrons at the sample, called the landing energy, and this landing energy is often not easy to predict. The landing energy may depend on factors such as the current density of the beam, the material of the sample and the electric field at the surface.

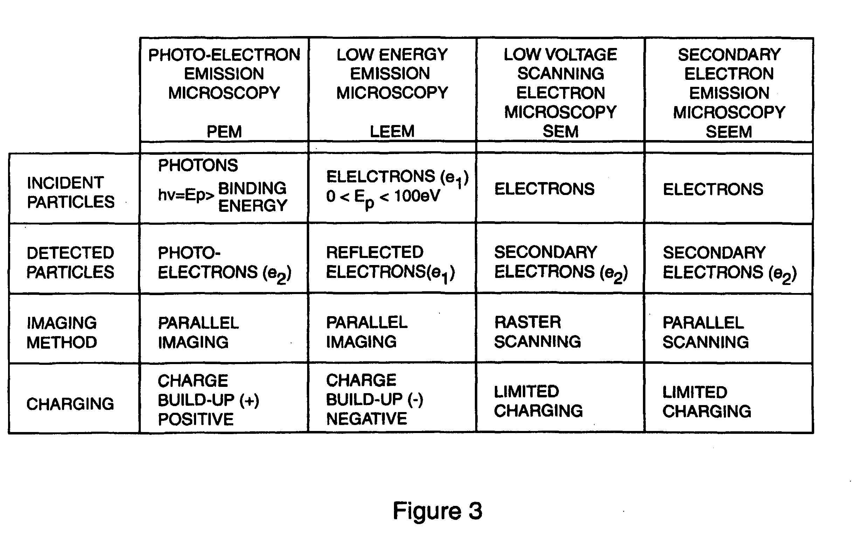

Figure 3 is a chart summarizing the differences between, and advantages of, the four PEEM, LEEM, SEM and SEEM techniques. PEEM uses photons instead of primary electrons to produce emitted secondary electrons. PEEM suffers from the problem of positive charge build-up on insulating sample target materials because secondary electrons are being knocked off the sample surface by the photons, but no negatively charged particles replace these secondary electrons. The inspecting photon beam of PEEM can be wide, and parallel imaging can be achieved.

In Low Energy Electron Microscopy (LEEM), a wide beam of primary electrons is projected at the inspection surface, and parallel imaging can be achieved. These primary electrons are relatively low in energy, and the imaging method involves reflecting these low-energy electrons from the surface. Because only low energy electrons are incident, primary electrons are reflected but few secondary electrons are emitted. Also, the low energy implies a negative charge build-up because these electrons are not sufficiently energetic to escape the sample surface.

In Scanning Electron Microscopy (SEM), relatively slow raster scanning imaging must be utilized because the electron beam is focused to a narrow spot size. SEM, however, produces energetic primary source electrons incident at energy E₂, which is a stable point on the yield curve, so that charge-neutral operation is attained. Energetic primary electrons produce secondary electrons in SEM.

In the Secondary Electron Emission Microscopy (SEEM) technique of the present invention, a beam of energetic primary electrons is directed at the sample surface with an energy Because a relatively wide beam of primary electrons is introduced, parallel imaging becomes possible, which is significantly faster than SEM imaging. Moreover, these primary electrons can be incident with an energy E₂ and/or can be accompanied by electrons of significantly lower energy such that the sample remains charge neutral. SEEM thus combines the most favorable attributes of LEEM and SEM.

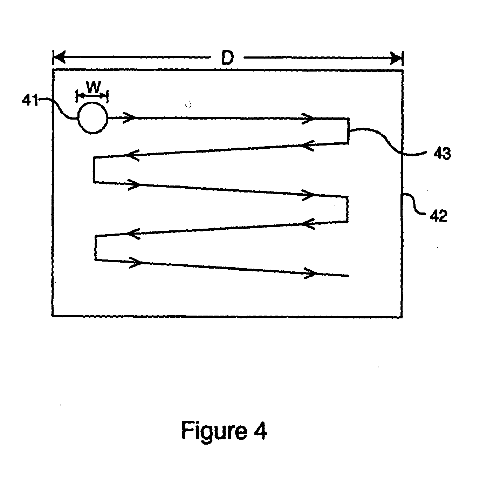

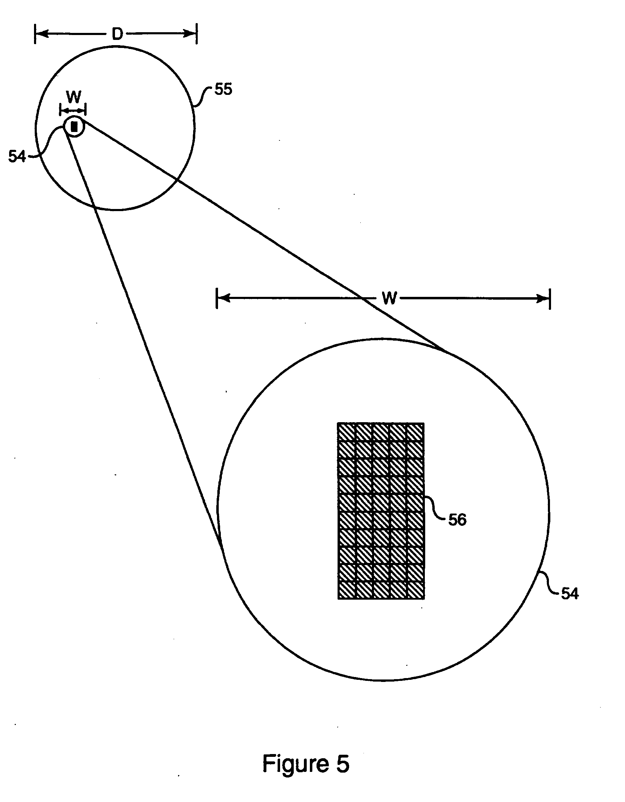

Figure 4 and 5 comparatively illustrate the respective imaging methods of Scanning Electron Microscopy and Secondary Electron Emission Microscopy. In Figure 4, a Scanning Electron Microscope produces a beam 41 of electrons and directs them at the surface of sample 42 having a characteristic dimension D. Beam 41 has a width "w", which is in the range of 5 to 100 nanometers (50-1000 Angstroms). This beam 41 is raster-scanned in a pattern represented by path 43 across the surface of sample 42. (The number of scan lines is greatly reduced from purposes of illustration.) In order to control the beam 41 so that it travels along raster path 43, it is preferred from the inspection system to include an electron beam steering apparatus for electromagnetically deflecting the electron beam 41. Electrostatic deflection could alternatively or additionally be used.

Figure 5 shows parallel imaging in the Secondary Electron Emission Microscopy inspection technique of the present invention. Beam 54 is produced from an electron gun source, and beam 54 has a width "W", typically about one to two millimeters, at the surface of sample 55. Sample 55 has the characteristic dimension D, which is much greater than the width W of the electron beam. In SEEM, the width of the electron beam 54 is much larger than in SEM, but it may still be possible and necessary to move the sample 55 with respect to the beam to scan the sample 55. However, in the preferred embodiment, SEEM requires only mechanical movement of the stage of the sample 55 with respect to beam 54, and not an electron beam deflection system for electromagnetically steering beam 41. Electromagnetic and/or electrostatic deflection could still be used, of course, and may be useful for such tasks as compensating for stage vibration or steering the wide beam along a serpentine path. The SEEM inspection system of the present invention can operate much faster than the SEM inspection system because SEEM images thousands or millions of pixels in parallel.

Figure 5 further shows a magnified view of the imaging portion of the beam 54 on the sample 55 to illustrate the parallel, multi-pixel imaging region 56 within beam 54. A rectangular detector array region 56 occupies a central portion of the beam 54 and defines the imaging aperture. (The detector array is either of the time delay integrating (TDI) or non-integrating type.) The detector array 56 images between about 500 thousand and one million pixels in parallel.

SEEM is therefore 500 thousand to one million times faster than SEM due to the number of pixels in the detector array. If SEEM spends one millisecond looking at a pixel, SEM can only take one or two nanoseconds for that pixel to capture the same data frame at 100 MHz. Accordingly, the current density at the sample surface in SEEM is 10⁶ (i.e. one million) times smaller than in SEM, which results in less damage to the sample. If, say, that 10,000 electrons per pixel are required for a good image, SEM must direct a larger number of electrons per unit time onto the pixel spot. In SEEM, the same number of electrons are spread out over a longer time because one million pixels are imaged simultaneously.

It further follows that SEEM has better noise reduction characteristics than SEM. At 100 MHz, SEM looks at each pixel for one nanosecond, while SEEM looks at each pixel for one millisecond. SEEM, therefore, averages out noise above one kHz, while SEM can only average out noise above 100 MHz. In defect detection applications, this implies fewer false positives and a better signal-to-noise ratio.

Besides the preferred method of using a second lower energy beam in conjunction with a first higher energy beam to control charge build-up, SEEM can obtain additional advantages in charge control by flooding the sample 55 with beam 54, but imaging only the central portion of the beam 54 to eliminate edge effects. Ordinarily, non-uniformities in charge on the imaging surface lead to imaging distortions by deflecting the beam. The sample surfaces at the edge of the beam 54 have less uniform charge distributions than the surfaces at the interior portion of the beam because there is no electron flux outside the circumferences of the beam diameter. There are further edge effects because of the residual charging in areas the beam had already scanned. By flooding an area 54 larger than the imaging area of the detector array region 56, these imaging distortions are avoided. In SEM, edge effects cannot be eliminated by this method because the beam diameter is too small for further aperturing. Additional techniques for reducing the effect of surface charge accumulation are taught in U.S. Patent No. 5,302,828 to Monahan.

The present invention optionally may include still other additional means for maintaining the charge balance at the sample. One possibility is to apply a supplemental electric field by attaching electrodes to the sample. A variable voltage control feeds current to the electrodes thereby supplying an additional degree of freedom towards charge balance stability. Another possibility is to introduce a low pressure gas, such as argon, into the vacuum chamber which contains the sample to control the charge balance. The low-pressure gas may act to prevent the accumulation of excess charge on the sample. While the above techniques are exemplary of additional control means for maintaining the charge stability of the sample, they are no mean all-inclusive, and other such techniques may exist or be subsequently discovered to regulate charge control.

Any of these additional charge control means optionally may be utilized with the flooding method of Monahan, supra. The use of an electron beam of a particular energy with respect with the E₂ value of the material is one method for maintaining a stable charge balance. The use of additional or alternative charge control means such as using a second low energy beam, flooding, electrodes, and/or low pressure gas provide other methods for maintaining this charge balance. The combination of these first and second order charge control mechanisms may optionally be used for a charge control apparatus.

It is useful to compare the limitations imposed by the maximum scan rate in SEEM and SEM. To summarize the advantages of SEEM over SEM:
Lower Noise. A longer image integration time is obtained for a given sample area. Averaging over longer sampling times results in less noise.
Less Image Distortion. By flooding a larger area on the sample than is imaged, a more uniform charge distribution is maintained from the imaged area, and edge effect distortion is eliminated.
Lower Current Densities. Lower current densities, made possible by parallel imaging and greater dwell times, imply that there is a reduced probability of damage to the sample.
Faster. Parallel imaging means that many pixels (e.g. one million) are imaged at the same time in SEEM. Only one pixel is imaged at one time in SEM.
No High Speed Scanning Electronics. These scanning systems are complex and expensive, but are not required in SEEM because of faster parallel imaging.

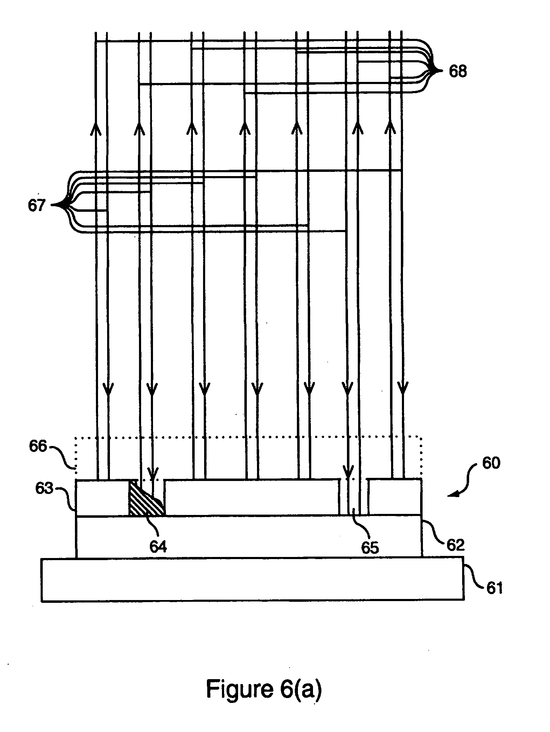

Figure 6(a) illustrates how defects in a via between the layers of a semiconductor device are detected in accordance with one embodiment of the present invention. An intermediate stage of fabrication of semiconductor device 60 is shown, In this example, semiconductor device 60 consists of a substrate 61, a metal layer 62 deposited on substrate 61, and an insulating layer 63 formed over metal layer 62. Vias or holes 64, 65 are shown extending through insulating layer 63 to metal layer 62. At a subsequent stage of fabrication, a second metal layer 66 is formed over insulating layer 63, and vias 64, 65 are filled with an electrically conductive material to form electrical connections between metal layers 62 and 66. At the present stage of fabrication, however, metal layer 66 has not yet been deposited, so it is only shown in dotted lines. Generally speaking, vias 64 and 65 are formed by etching insulating layer 63. Via 64, however, is herein shown to be clogged while via 65 is clear. Via 64 may, for example, become clogged with foreign material, or it may be clogged because of imperfections in the etching process. In either event, via 64 represents a defective via, while via 65 represents a perfect via.

Figure 6(a) further shows a beam 67 of primary electrons incident normal to the surface of semiconductor device 60 onto insulating layer 63. This beam 67 represents the combination of a first beam having higher energy electrons and a second beam having lower energy electrons. Because layer 63 is an insulating material, electron mobility on layer 63 is limited. Insulating layer 63 therefore has a tendency to collect charge on it surface, and this has led to the charge build-up problems associated with prior art inspection techniques such as LEEM. However, in the Secondary Electron Emission Microscopy (SEEM) technique of the present invention, the energy of the higher energy electrons in beam 67 could be chosen to be sufficiently near the E₂ value of the material of insulating layer 63, or could be at a different energy, so long as the lower energy beam has an energy appropriate to control charging of layer 63. Thus, upon illumination by primary electron beam 67, a secondary electron beam 68 is produced by insulating material 63 with minimal build-up of charge on surface 63 of the material. The energy of the lower energy electrons in beam 67 is selected to minimize charge build-up on the sample surface resulting from the higher energy electrons.

Returning electron beam 68 may be emitted in a direction normal to the surface of insulating layer 63, and in a sense opposite to primary electron beam 67. Returning electron beam 68 contains information about the defective and perfect vias 64, 65, and this information passes back through the optical system, is detected and subsequently processed to enable the operator to determine whether the semiconductor device 60 is defective.

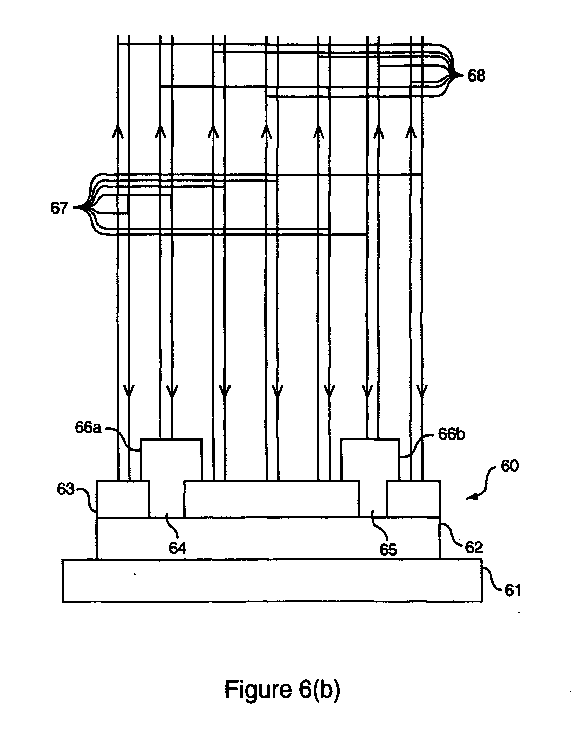

Figure 6(b) shows electron beam inspection of the semiconductor device 60 of Figure 6(a) at a subsequent stage of construction. Metal lines 66a and 66b extend in a direction perpendicular to the page to connect metal layer 62 through vias 64, 65, thereby providing electrical contact between lines 66a, 66b and layer 62. Primary electron beam 67 is incident on semiconductor device 60, and particularly on meal lines 66a, 66b and insulating layer 63. Inspective imaging of the surface of metal lines 66a, 66b and insulating layer 63 can be achieved with voltage contrast information derived from returning electron beam 68.

Process control monitoring for the semiconductor industry is thereby improved with electron beam inspection of the present invention as compared with optical beam inspection by reducing or eliminating false positives due to grain structures and color noise. Once a defect has been identified, it may be repaired with a procedure such as focused ion beam implantation if the defect is critical. The information derived from the inspection of substrates can also be used to improve yields of subsequently fabricated semiconductor devices. The SEEM system of the present invention, if desired, could be used in situ as part of a semiconductor wafer manufacturing apparatus, in which wafers could be inspected before, during or after processing, and a common robot could be used for handling the wafers and moving them between inspection and processing stations. The SEEM could also be located in a vacuum chamber that is additionally used for other fabrication purposes, such as ion implantation or deposition. Data from the inspection can be fed forward to subsequent processing stations or fed back to prior processing stations to provide improved automated process control.

Since they contain different kinds of information, it is desirable to separate the images originating from the high and low energy illuminating beams. One novel means of separating the low energy mirror and higher energy scattering images in a dual beam SEEM exploits the principle of synchronous detection. In this mode, the low energy beam and the higher energy beam are not superimposed, but rather are alternately turned on and off (toggled). The image is recorded only while the desired mirror or scattering image is present. During the unwanted part of the toggle cycle, the image beam is also blanked off.

To maintain the desirable charge balance from the low energy beam, the switching rates between the two images can be selected to meet certain conditions. The rate of change in surface potential (charge buildup) dV/dt depends upon the difference Jₐ - Jₛ (charge/sec/sq.cm) between the absorbed (Jₐ) and scattered (Jₛ) current densities, and upon the surface layer capacitance C per square cm of surface area, in such a way that dV/dt = ( Jₐ - Jₛ) / C. If ΔV is the tolerable increase in surface potential (approx. 0.1 Volt) during one cycle, then the beams must be toggled in a time less than Δt < C ΔV / ( Jₐ - Jₛ ). If the toggle time Δt for an image element is sufficiently short, the image will behave as though the two beams were actually superimposed, even though the image from only one of the beams is observed. In comparison with the image subtraction method above, this method has the advantage of rejecting noise as well as contrast from the unwanted image.

This mode of operation requires that both the illumination beam and the image beam be turned on and off electron optically (blanked). In one embodiment, the control grid of an electron gun is switched between two voltages to blank the illumination beams. The beam is off when the grid is biased sufficiently negative to prevent electrons from leaving the cathode. The beam is on when the grid is biased more positive. In another embodiment, a beam is deflected (where the deflection is accomplished magnetically, electrostatically or both) at an image plane, so that it passes through an aperture only when the beam should be unblanked. Both of these blanking methods may be applied in a dual beam SEEM to separate its images.

In another embodiment of the invention, both mirror mode and secondary/backscatter mode are used sequentially to create images having different characteristics. In this embodiment, each type of image is sequentially produced, as in the preceding embodiment. However, the image beam is not blanked off, because there is no unwanted part of the toggle cycle. Instead, each type of image is used to determine features of the substrate under observation. As an example, in an "array mode" or a "die to die mode" of semiconductor inspection, a mirror mode image of a first portion of a die is compared to a mirror mode image of a corresponding portion of an array from the same die (for array mode), or a corresponding portion of another die (for die to die mode). A similar die to die comparison or array comparison can then be performed for the secondary/backscatter image. Information derived from both types of comparison can be used to better identify and characterize defects on semiconductor substrates. A more detailed description of die to die mode comparison can be found in commonly assigned US Patent No. 5,502,306.

More generally, the secondary electron emission microscopy of the present invention is used to inspect defects in any semiconductor device, thin film magnetic head, reticle for semiconductor fabrication or flat panel (e.g., liquid crystal or field effect) display. Insulating, semiconducting, or conducting materials, or even superconductors and plasmas, are capable of being imaged with SEEM. A typical semiconductor fabrication process involves ultraviolet reduction projection of a reticle pattern produced for a wafer design, followed by chemical etching for each of the device layers. Alternatively, semiconductor devices are patterned with ion beams or etching, or by CMP processing. Process inspection and monitoring of the intermediate and final products is then performed with the method of the present invention. The SEEM system of the present invention could also be used for defect review, in which previously inspected wafers are reviewed and the defects located thereon may be characterized

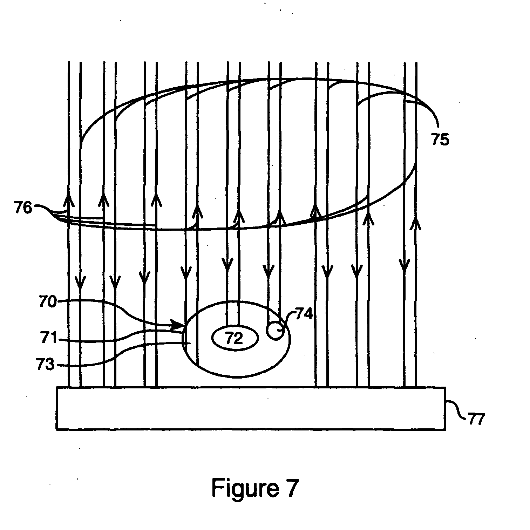

Figure 7 illustrates how the Secondary Electron Emission Microscope (SEEM) of the present invention is applied to studying a biological sample 70 on a stage carrier 77. Biological sample 70 has various features 71, 72, 73 and 74. For example, sample 70 may be a cell including a cell wall 71, a cell nucleus 72, protoplasm 73, and mitochondrion 74. Or, sample 70 may be human tissue including muscle 71, bone 72, fluid 73 and malignant cells 74. A beam 75 of primary electrons is incident normally on sample 70. A beam 76 of returning electrons is produced upon illumination of cell 70 with beam 75, and beam 76 passes normally back through the electron optical system. Information about cell 70 is encoded in beam 76, and is detected and processed to obtain information about cell 70.

Although the foregoing invention has been described in some detail for purposes of clarity of understanding, it will be apparent that certain changes and modifications may be practiced within the scope of the appended claims. It should be noted that there are many alternative ways of implementing both the process and apparatus of the present invention. Accordingly, the present embodiments are to be considered as illustrative and not restrictive, and the invention is not to be limited to the details given herein, but may be modified within the scope of the appended claims.

## Claims

1. An apparatus (100) for inspecting a sample (9) comprising:
a first electron beam generator (10) arranged to direct a first electron beam having a first range of energy levels toward a first area of the sample;
a second electron beam generator (8) arranged to direct a second electron beam having a second range of energy levels toward a second area of the sample, wherein the second area of the sample at least partly overlaps with the first area and the second range of energy levels are different from the first range such that charge build up on the sample surface caused by the first electron beam is minimized;
wherein the first and second electron beam generators comprise a first electron gun source arranged to generate the first electron beam and a second electron gun source arranged to generate the second electron beam; and,
a detector (20) arranged to detect secondary electrons originating from the sample as a result of the first and second electron beam interacting with the sample so as to image a plurality of pixels in parallel;
wherein
the first electron beam generator is adapted to generate a first electron beam having a width sized to produce a spot size on the surface of the sample in the range of 0.1 to 100 millimetres; wherein
the detector is adapted to image between 500,000 and 1,000,000 pixels in parallel; and,
wherein the apparatus further comprises a magnetic beam separator (14) arranged to direct the first and second electron beams toward the sample (9) and bend the secondary electrons along an image path (16) on to an imaging plane of the detector.

2. An apparatus as recited in claims 1, wherein the first (10) and second (8) electron beam generator are arranged to concurrently produce the first and second beams.

3. An apparatus as recited in any of claims 1 or 2, wherein the first electron beam generator is adapted to generate the first electron beam having a width sized to produce a spot size on the sample in the range of 1 to 2 millimeters.

4. An apparatus as recited in claims 1 or 3, wherein the first and second electron beam generators are adapted to generate the first and second electron beams, wherein the first range of energy levels result in a landing energy value of 1keV for the first beam and the second range of energy levels result in a landing energy of about 0 eV for the second beam.

5. An apparatus as recited in any of claims 1-4, wherein the second area of the sample that receives the second beam completely encompasses the first area of the sample that receives the first beam.

6. An apparatus as recited in any of claims 1-5, further comprising
an objective lens (22) arranged to focus the first and second beams onto the sample (9).

7. An apparatus as recited in any of claims 1-6, wherein the detector (20) is in the form of:
a projection electron lens (19) for focusing the secondary electrons onto an image plane;
an electron imager (20a) arranged within the image plane to receive secondary electrons and convert the secondary electron into photons;,and
an optical detector (20b) arranged to receive the photons and generate an image of the sample.

8. An apparatus as recited in claim 7, wherein the optical detector (20b) is in the form of a camera or a time delay integration detector.

9. An apparatus as recited in any of claims 1-6, wherein the detector (20) is in the form of a projection electron lens (19) for focusing the secondary electrons onto an image plane; and
a back thinned delay integration detector arranged within the image plane to receive and detect the secondary electrons.

10. An apparatus as recited in any of claims 1-9, where the second electron beam generator is adapted to generate the second electron beam so that the second range of energy levels lock the surface of the sample into a voltage value such that charge build-up is discharged from the surface of the sample.

11. An apparatus as recited in any of claims 1-10, where the second electron beam generator is adapted to generate the second electron beam so that the second range of energy levels are such that electrons are deposited on a surface of the sample to reduce positive charge build-up caused by the first electron beam.

12. A method for controlling charging of a surface of a sample while exposing the surface to a beam of charged particles, comprising:
exposing the surface of the sample to a first set of electrons in a first electron beam, the first set of electrons having energies within a first range;
exposing the surface to a second set of electrons in a second electron beam, the second set of electrons having energies within a second range, different from the first range, such that charge build up on the sample surface caused by the first electron beam is minimized; and
detecting secondary electrons originating from the sample as a result of the first and second electron beams interacting with the sample so as to image a plurality of pixels in parallel, wherein
the first electron beam has a width sized to produce a spot size on the surface of the sample in the range of 0.1 to 100 millimetres; wherein
the detector images between 500,000 and 1,000,000 pixels in parallel; and wherein
the first and second beams are directed towards the sample by a magnetic beam separator (14) and the secondary electrons are bent along an image path (16) on to an imaging plane of the detector by the magnetic beam separator.

13. The method of claim 12, wherein said surface is alternately exposed to said first electron beam and said second electron beam.

14. The method of claim 12-or 13, wherein said first beam is an incident beam in an electron beam microscope.

15. The method of any of claims 12-14, wherein said second electron beam is provided in the form of a defocused beam.

16. The method of claim 15, wherein said defocused beam is incident on said substrate over a larger area than an area of said substrate over which said first beam is incident.

17. The method of any of claims 12-16, further comprising exposing said surface to an inert gas.

18. The method of claim 17, wherein said inert gas comprises positive ions, and wherein said ions land on said surface and carry away excess negative charge from said surface.

## Patentansprüche

1. Vorrichtung (100) zum Untersuchen einer Probe (9), umfassend:
einen ersten Elektronenstrahlgenerator (10), welcher angeordnet ist, einen ersten Elektronenstrahl mit einem ersten Bereich von Energiepegeln in Richtung eines ersten Bereichs der Probe zu richten;
einen zweiten Elektronenstrahlgenerator (8), welcher angeordnet ist, einen zweiten Elektronenstrahl mit einem zweiten Bereich von Energiepegeln in Richtung eines zweiten Bereichs der Probe zu richten, wobei der zweite Bereich der Probe zumindest teilweise den ersten Bereich überlappt und der zweite Bereich von Energiepegeln derart unterschiedlich zu dem ersten Bereich ist, dass ein Ladungsaufbau auf der Probenfläche, welcher von dem ersten Elektronenstrahl bewirkt wird, minimiert wird;
wobei der erste und der zweite Elektronenstrahlgenerator eine erste Elektronenkanonenquelle, welche ausgestaltet ist, den ersten Elektronenstrahl zu erzeugen, und eine zweite Elektronenkanonenquelle, welche ausgestaltet ist, den zweiten Elektronenstrahl zu erzeugen, umfassen; und
einen Detektor (20), welcher angeordnet ist, Sekundärelektronen, welche als Ergebnis des ersten und des zweiten Elektronenstrahls, welche mit der Probe wechselwirken, von der Probe stammen, zu erfassen, um mehrere Bildpunkte parallel abzubilden;
wobei der erste Elektronenstrahlgenerator ausgestaltet ist, einen ersten Elektronenstrahl zu erzeugen, welcher eine Breite aufweist, die so dimensioniert ist, dass sie eine Punktgröße auf der Fläche der Probe in dem Bereich von 0,1 bis 100 Millimetern erzeugt; wobei
der Detektor ausgestaltet ist, zwischen 500.000 und 1.000.000 Bildpunkte parallel abzubilden; und
wobei die Vorrichtung ferner eine magnetische Strahltrennvorrichtung (14) umfasst, welche ausgestaltet ist, den ersten und den zweiten Elektronenstrahl in Richtung der Probe (9) zu leiten und die Sekundärelektronen entlang eines Abbildungspfads (16) auf eine Abbildungsfläche des Detektors zu beugen.

2. Vorrichtung nach Anspruch 1, wobei der erste (10) und der zweite (8) Elektronenstrahlgenerator angeordnet sind, den ersten und den zweiten Strahl gleichzeitig zu erzeugen.

3. Vorrichtung nach Anspruch 1 oder 2, wobei der erste Elektronenstrahlgenerator ausgestaltet ist, den ersten Elektronenstrahl zu erzeugen, welcher eine Breite aufweist, die so dimensioniert ist, dass sie eine Punktgröße auf der Probe in dem Bereich von 1 bis 2 Millimetern erzeugt.

4. Vorrichtung nach einem der Ansprüche 1 oder 3, wobei der erste und der zweite Elektronenstrahlgenerator ausgestaltet sind, den ersten und den zweiten Elektronenstrahl zu erzeugen, wobei der erste Bereich von Energiepegeln zu einem Landeenergiewert von 1 keV für den ersten Strahl führt und der zweite Bereich von Energiepegeln zu einer Landeenergie von näherungsweise 0 eV für den zweiten Strahl führt.

5. Vorrichtung nach einem der Ansprüche 1-4, wobei der zweite Bereich der Probe, welcher den zweiten Strahl vollständig aufnimmt, den ersten Bereich der Probe, welcher den ersten Strahl aufnimmt, vollständig umgibt.

6. Vorrichtung nach einem der Ansprüche 1-5, ferner umfassend eine Objektivlinse (22), welche angeordnet ist, den ersten und den zweiten Strahl auf die Probe (9) zu fokussieren.

7. Vorrichtung nach einem der Ansprüche 1-6, wobei der Detektor (20) in Form
einer Projektionselektronenlinse (19) zum Fokussieren der Sekundärelektronen auf eine Bildebene;
einer Elektronenbildgebungsvorrichtung (20a), welche innerhalb der Bildebene angeordnet ist, um Sekundärelektronen zu empfangen und die Sekundärelektronen in Photonen umzuwandeln; und
eines optischen Detektors (20b), welcher angeordnet ist, die Photonen zu empfangen und ein Bild der Probe zu erzeugen, ausgestaltet ist.

8. Vorrichtung nach Anspruch 7, wobei der optische Detektor (20b) in Form einer Kamera oder eines Zeitverzögerungsintegrationsdetektors ausgestaltet ist.

9. Vorrichtung nach einem der Ansprüche 1-6, wobei der Detektor (20) in Form einer Projektionselektronenlinse (19) zum Fokussieren der Sekundärelektronen auf eine Bildebene und
eines hinten verdünnten Verzögerungsintegrationsdetektors, welcher innerhalb der Bildebene angeordnet ist, um die Sekundärelektronen zum empfangen und zu erfassen, ausgestaltet ist.

10. Vorrichtung nach einem der Ansprüche 1-9, wobei der zweite Elektronenstrahlgenerator ausgestaltet ist, den zweiten Elektronenstrahl derart zu erzeugen, dass der zweite Bereich von Energiepegeln die Fläche der Probe auf einen Spannungswert derart feststellt, dass ein Ladungsaufbau von der Fläche der Probe entladen wird.

11. Vorrichtung nach einem der Ansprüche 1-10, wobei der zweite Elektronenstrahlgenerator ausgestaltet ist, den zweiten Elektronenstrahl derart zu erzeugen, dass der zweite Bereich von Energiepegeln derart ist, dass Elektronen auf einer Fläche der Probe angeordnet werden, um einen von dem ersten Elektronenstrahl bewirkten positiven Ladungsaufbau zu verringern.

12. Verfahren zum Steuern eines Aufladens einer Fläche einer Probe während die Fläche einem Strahl von geladenen Partikeln ausgesetzt ist, umfassend:
Aussetzen der Fläche der Probe einer ersten Gruppe von Elektronen aus einem ersten Elektronenstrahl, wobei die erste Gruppe von Elektronen Energien innerhalb eines ersten Bereichs aufweist;
Aussetzen der Fläche einer zweiten Gruppe von Elektronen aus einem zweiten Elektronenstrahl, wobei die zweite Gruppe von Elektronen Energien innerhalb eines zweiten Bereichs aufweist, welcher unterschiedlich zu dem ersten Bereich ist, so dass ein von dem ersten Elektronenstrahl bewirkter Ladungsaufbau auf der Probenfläche minimiert wird; und
Erfassen von Sekundärelektronen, welche als Ergebnis des ersten und des zweiten Elektronenstrahls, welche mit der Probe wechselwirken, von der Probe stammen, um mehrere Bildpunkte parallel abzubilden,
wobei der ersten Elektronenstrahl eine Breite aufweist, welche dimensioniert ist, um eine Punktgröße auf der Fläche der Probe in dem Bereich von 0,1 bis 100 Millimetern zu erzeugen;
wobei der Detektor zwischen 500.000 und 1.000.000 Bildpunkte parallel abbildet; und
wobei der ersten und der zweite Strahl durch eine magnetische Strahltrennvorrichtung (14) in Richtung der Probe geleitet werden und die Sekundärelektronen entlang eines Abbildungspfads (16) auf eine Abbildungsebene des Detektors durch die magnetische Strahltrennvorrichtung gebeugt werden.

13. Verfahren nach Anspruch 12, wobei die Fläche abwechselnd dem ersten Elektronenstrahl und dem zweiten Elektronenstrahl ausgesetzt wird.

14. Verfahren nach Anspruch 12 oder 13, wobei der erste Strahl ein einfallender Strahl in einem Elektronenstrahlmikroskop ist.

15. Verfahren nach einem der Ansprüche 12-14, wobei der zweite Elektronenstrahl in Form eines defokussierten Strahls bereitgestellt wird.

16. Verfahren nach Anspruch 15, wobei der defokussierte Strahl auf das Substrat über einen größeren Bereich als einen Bereich des Substrats, auf welchen der erste Strahl einfällt, einfällt.

17. Verfahren nach einem der Ansprüche 12-16, ferner umfassend ein Aussetzen der Fläche einem Inertgas.

18. Verfahren nach Anspruch 17, wobei das Inertgas positive Ionen umfasst, und wobei die Ionen auf der Fläche landen und eine überschüssige negative Ladung von der Fläche forttragen.

## Revendications

1. Appareil (100) servant à inspecter un échantillon (9), comprenant :
un premier générateur (10) de faisceau d'électrons agencé de manière à diriger un premier faisceau d'électrons possédant une première plage de niveaux d'énergie en direction d'une première zone de l'échantillon ;
un second générateur (8) de faisceau d'électrons agencé de manière à diriger un second faisceau d'électrons possédant une seconde plage de niveaux d'énergie en direction d'une seconde zone de l'échantillon, où la seconde zone de l'échantillon chevauche au moins partiellement la première zone et la seconde plage de niveaux d'énergie est différente de la première plage de manière à ce que l'accumulation de charges sur la surface de l'échantillon créées par le premier faisceau d'électrons soit minimisée ;
dans lequel les premier et second générateurs de faisceau d'électrons comprennent une première source de type canon à électrons agencée de manière à générer le premier faisceau d'électrons et une seconde source de type canon à électrons agencée de manière à générer le second faisceau d'électrons ; et
un détecteur (20) agencé de manière à détecter les électrons secondaires provenant de l'échantillon créés par l'interaction entre les premier et second faisceaux d'électrons et l'échantillon afin de former une image constituée d'une pluralité de pixels parallèles ;
dans lequel
le premier générateur de faisceau d'électrons est adapté pour générer un premier faisceau d'électrons possédant une largeur dimensionnée pour produire une taille de spot sur la surface de l'échantillon située dans la plage allant de 0,1 à 100 millimètres ; dans lequel
le détecteur est adapté pour capter une image constituée de 500 000 à 1 000 000 de pixels parallèles ; et,
dans lequel l'appareil comprend en outre un séparateur magnétique (14) de faisceau agencé de manière à diriger les premier et second faisceaux d'électrons en direction de l'échantillon (9) et à réfracter les électrons secondaires le long d'un passage (16) pour image sur un plan imageur du détecteur.

2. Appareil selon la revendication 1, dans lequel les premier (10) et second (8) générateurs de faisceau d'électrons sont agencés de manière à produire simultanément les premier et second faisceaux.

3. Appareil selon l'une quelconque des revendications 1 ou 2, dans lequel le premier générateur de faisceau d'électrons est adapté pour générer le premier faisceau d'électrons possédant une largeur dimensionnée pour produire une taille de spot sur la surface de l'échantillon située dans la plage allant de 1 à 2 millimètres.

4. Appareil selon la revendication 1 ou 3, dans lequel les premier et second générateurs de faisceau d'électrons sont adaptés pour générer les premier et second faisceaux d'électrons, dans lesquels la première plage de niveaux d'énergie donne une valeur d'énergie d'arrivée de 1 keV pour le premier faisceau et la seconde plage de niveaux d'énergie donne une énergie d'arrivée d'environ 0 eV pour le second faisceau.

5. Appareil selon l'une quelconque des revendications 1 à 4, dans lequel la seconde zone de l'échantillon qui reçoit le second faisceau englobe complètement la première zone de l'échantillon qui reçoit le premier faisceau.

6. Appareil selon l'une quelconque des revendications 1 à 5, comprenant en outre :
une lentille de focalisation (22) agencée de manière à focaliser les premier et second faisceaux sur l'échantillon (9).

7. Appareil selon l'une quelconque des revendications 1 à 6, dans lequel le détecteur (20) se présente sous la forme :
d'une lentille de projection d'électrons (19) pour focaliser les électrons secondaires sur un plan image ;
d'un imageur à électrons (20a) agencé dans le plan image pour recevoir les électrons secondaires et convertir les électrons secondaires en photons ; et
d'un détecteur optique (20b) agencé pour recevoir les photons et générer une image de l'échantillon.

8. Appareil selon la revendication 7, dans lequel le détecteur optique (20b) se présente sous la forme d'une caméra ou d'un détecteur à report et intégration.

9. Appareil selon l'une quelconque des revendications 1 à 6, dans lequel le détecteur (20) se présente sous la forme d'une lentille de projection d'électrons (19) pour focaliser les électrons secondaires sur un plan image ; et
d'un détecteur à report et intégration type back thinned agencé dans le plan image de manière à recevoir et détecter les électrons secondaires.

10. Appareil selon l'une quelconque des revendications 1 à 9, dans lequel le second générateur de faisceau d'électrons est adapté pour générer le second faisceau d'électrons de telle sorte que la seconde plage de niveaux d'énergie bloque la surface de l'échantillon dans une valeur de tension de manière à ce que la charge accumulée se décharge de la surface de l'échantillon.

11. Appareil selon l'une quelconque des revendications 1 à 10, dans lequel le second générateur de faisceau d'électrons est adapté pour générer le second faisceau d'électrons de telle sorte que la seconde plage de niveaux d'énergie soit telle que les électrons se déposent sur la surface de l'échantillon pour réduire l'accumulation de charges positives créées par le premier faisceau d'électrons.

12. Procédé de contrôle de la charge d'une surface d'un échantillon tout en exposant la surface à un faisceau de particules chargées, comprenant :
l'exposition de la surface de l'échantillon à un premier ensemble d'électrons se trouvant dans un premier faisceau d'électrons, le premier ensemble d'électrons possédant des énergies se trouvant dans une première plage ;
l'exposition de la surface à un second ensemble d'électrons se trouvant dans un second faisceau d'électrons, le second ensemble d'électrons possédant des énergies se trouvant dans une seconde plage, différente de la première plage, de manière à ce que l'accumulation de charges sur la surface de l'échantillons créées par le premier faisceau d'électrons soit minimisée ; et
la détection des électrons secondaires provenant de l'échantillon créés par l'interaction entre les premier et second faisceaux d'électrons et l'échantillon afin de former une image constituée d'une pluralité de pixels parallèles ; dans lequel
le premier faisceau d'électrons possède une largeur dimensionnée pour produire une taille de spot sur la surface de l'échantillon située dans la plage allant de 0,1 à 100 millimètres ; dans lequel
le détecteur capte une image constituée de 500 000 à 1 000 000 de pixels parallèles ; et dans lequel
les premier et second faisceaux sont dirigés en direction de l'échantillon par un séparateur magnétique (14) de faisceau et les électrons secondaires sont réfractés le long d'un passage (16) pour image sur un plan imageur du détecteur par le séparateur magnétique de faisceau.

13. Procédé selon la revendication 12, dans lequel ladite surface est exposée en alternance audit premier faisceau d'électrons et audit second faisceau d'électrons.

14. Procédé selon la revendication 12 ou 13, dans lequel ledit premier faisceau est un faisceau incident dans un microscope à faisceau d'électrons.

15. Procédé selon l'une quelconque des revendications 12 à 14, dans lequel ledit second faisceau d'électrons est fourni sous la forme d'un faisceau défocalisé.

16. Procédé selon la revendication 15, dans lequel ledit faisceau défocalisé est incident sur ledit substrat sur une plus grande zone qu'une zone dudit substrat sur laquelle ledit premier faisceau est incident.

17. Procédé selon l'une quelconque des revendications 12 à 16, comprenant en outre l'exposition de ladite surface à un gaz inerte.

18. Procédé selon la revendication 17, dans lequel ledit gaz inerte comprend des ions positifs et dans lequel lesdits ions se posent sur ladite surface et emportent la charge négative en excès de ladite surface.
